Europäisches Patentamt

European Patent Office

Office européen des brevets

(11) Numéro de publication: **0 356 347**
**A1**

## (12) DEMANDE DE BREVET EUROPEEN

(21) Numéro de dépôt: **89420295.1**

(22) Date de dépôt: **09.08.89**

(51) Int. Cl.⁵: **G 01 R 31/36**

(30) Priorité: **17.08.88 FR 8811018**

(43) Date de publication de la demande:
**28.02.90 Bulletin 90/09**

(84) Etats contractants désignés: **DE GB SE**

(71) Demandeur: **MERLIN GERIN**
**2, chemin des Sources**
**F-38240 Meylan (FR)**

(72) Inventeur: **Caillet, Pierre**
**Merlin Gerin Sce. Brevets**
**F-38050 Grenoble Cédex (FR)**

**Jean, Robert**
**Merlin Gerin Sce. Brevets**
**F-38050 Grenoble Cédex (FR)**

**Laffont, Serge**
**Merlin Gerin Sce. Brevets**
**F-38050 Grenoble Cédex (FR)**

**Prunier, Michel**
**Merlin Gerin Sce. Brevets**
**F-38050 Grenoble Cédex (FR)**

**Trichet, Philippe**
**Merlin Gerin Sce. Brevets**
**F-38050 Grenoble Cédex (FR)**

(74) Mandataire: **Kern, Paul et al**
**Merlin Gerin Sce. Brevets 20, rue Henri Tarze**
**F-38050 Grenoble Cédex (FR)**

(54) **Système de surveillance automatique en milieu explosif d'une source de courant continu à batteries d'accumulateurs.**

(57) Un système de surveillance automatique de batteries d'accumulateurs répartis dans des locaux batteries (16,18) comporte un satellite d'acquisition (22) associé à un capteur pour la mesure de différents paramètres physiques représentatifs, de l'état de fonctionnement d'un accumulateur témoin, notamment la densité, la température et le niveau de l'électrolyte, un concentrateur de données (52,54) situé à l'extérieur du local batteries (16,18) correspondant et agencé pour communiquer par ondes radio-électriques avec le satellite d'acquisition (22), et une unité de traitement centralisée (12) reliée au concentrateur (52,54) par un réseau câblé de communication (56) bidirectionnelle.

FIG.1

EP 0 356 347 A1

**Description**

## SYSTEME DE SURVEILLANCE AUTOMATIQUE EN MILIEU EXPLOSIF D'UNE SOURCE DE COURANT CONTINU A BATTERIES D'ACCUMULATEURS.

L'invention est relative à un système de surveillance automatique d'une source de courant continu à batteries d'accumulateurs réparties dans des locaux batteries éloignés d'une unité de traitement centralisée associée à un écran d'affichage pour indiquer la charge et la capacité disponible par batterie et pour dialoguer avec l'opérateur, le système comprenant des moyens de surveillance de certains paramètres physiques représentatifs de l'état de fonctionnement de tous les accumulateurs ou de certains accumulateurs témoins dans chaque batterie, notamment la densité, la température, le niveau de l'électrolyte contenu dans ledit accumulateur témoin, et la tension de ce même accumulateur.

Dans les sous-marins à propulsion classique ou nucléaire, une ou deux batteries assurent la propulsion et l'alimentation en énergie électrique du sous-marin en plongée (propulsion classique) ou en mode secours (propulsion nucléaire).

Une batterie de sous-marin est constituée par une pluralité d'accumulateurs, reliés électriquement en série.

Les accumulateurs sont disposés selon plusieurs rangées dans un ou deux locaux batteries dans les parties avant et arrière du sous-marin.

Chaque local batterie se présente comme un local étanche, en dépression, et ventilé pour éliminer l'hydrogène dégagé par les accumulateurs lors des cycles de charge et de décharge. Le local batterie constitue un environnement explosible, qui peut devenir explosif, en fonctionnement anormal (ventilation stoppée...).

Le commandant du sous-marin doit pouvoir d'une part estimer régulièrement la capacité restante de sa batterie, pour l'utiliser de façon optimale en fonction des circonstances, et d'autre part, surveiller l'état de la batterie pour détecter les accumulateurs défectueux.

Ces deux fonctions, estimation de charge et surveillance de la batterie, nécessitent le contrôle fréquent de différents paramètres représentatifs de l'état de la batterie, notamment:
. la densité d'électrolyte de certains accumulateurs témoins
. la température d'électrolyte de ces mêmes accumulateurs
. le niveau d'électrolyte de ces accumulateurs
. la tension de ces accumulateurs.

Actuellement, un marin descend plusieurs fois par jour dans le local batterie; en combinaison, gants et lunettes de protection contre les projections d'acide, il rampe sur les capots de batterie pour peser l'acide, mesurer la température et le niveau de certains accumulateurs témoins.

Il est connu de remplacer ce contrôle humain à rondes locales intermittentes par un système de surveillance automatique des paramètres des accumulateurs (voir US-A-4.280.097). Un tel dispositif nécessite des câbles de liaison entre les différents accumulateurs et des concentrateurs de données, ce qui complique la maintenance dans le local batterie et ne se prête pas à la modularité de l'architecture.

L'objet de l'invention consiste à réduire l'encombrement et à perfectionner la fiabilité, la sécurité et la maintenabilité d'un système de surveillance automatique de batteries.

Il consiste d'autre part, à concevoir un système modulaire qui permet de choisir le nombre d'accumulateurs à surveiller par batterie.

Le système de surveillance selon l'invention est caractérisé en ce que les moyens de surveillance et communication comportent:
- un satellite d'acquisition par accumulateur surveillé, connecté à un capteur plongé dans l'électrolyte pour la mesure des paramètres de cet accumulateur, le satellite étant logé à l'intérieur du local batterie correspondant, en étant autoalimenté électriquement par la tension présente aux bornes de polarités opposées de l'accumulateur,
- un concentrateur de données, situé à l'extérieur dudit local et agencé pour communiquer d'une part, par ondes avec le satellite d'acquisition de chaque accumulateur surveillé, et d'autre part, avec l'unité de traitement centralisée par l'intermédiaire d'un réseau cablé.

L'alimentation d'un satellite d'acquisition s'effectue automatiquement à partir de la tension continue (2 Volts) de l'accumulateur auquel il est affecté. Le rôle du satellite consiste à réaliser les mesures de paramètres de cet accumulateur, et de les transmettre hors du local batterie via un concentrateur vers une unité centrale munie d'un écran d'affichage et placée au poste de pilotage. Les mesures y seront traitées pour calculer la charge et la capacité restante de la batterie, et pour alarmer et réaliser d'autres traitements.

Le système de transmission sans fil par ondes entre le concentrateur et les satellites peut s'effectuer par ondes radioélectriques. Le choix de la communication par ondes radioélectriques entre les satellites et le concentrateur de données présente les avantages suivants:
- faible encombrement et maintenance aisée des équipements internes au local batterie, du fait de l'absence de câbles;
- adaptation très facile du système à toutes les batteries de sous-marin;
- pas de limitation du nombre de satellites dans chaque local;
- faible consommation des circuits de transmission équipant les satellites.

Le satellite d'acquisition comporte une carte de transmission à circuit émetteur-récepteur équipé d'une première antenne capable d'émettre des données de mesure vers le concentrateur et de recevoir des ordres en provenance de ce dernier. La transmission radio entre le satellite d'acquisition et le concentrateur s'opère par exemple par ondes VHF et modulation de fréquence.

Le concentrateur de données de chaque local batterie comporte un circuit multiplexeur de données, et une carte de transmission à circuit émetteur-récepteur reliée à une deuxième antenne disposée à l'intérieur du local batterie, un câble de liaison traversant la paroi du local batterie pour relier le concentrateur à la deuxième antenne. La paroi comporte avantageusement un écran d'isolement constituant une cage de Faraday autorisant exclusivement la transmission radio interne entre les première et deuxième antennes respectives du satellite et du concentrateur.

Les satellites d'acquisition et le capteur constituent des ensembles de sécurité en ambiance explosive grâce à l'application des modes de protections par sécurité intrinsèque et/ou encapsulage.

Le système de transmission sans fil peut encore être du type optique, par exemple à infrarouge.

D'autres avantages et caractéristiques ressortiront plus clairement de la description qui va suivre d'un mode de réalisation de l'invention donné à titre d'exemple non limitatif, et représenté aux dessins annexés dans lesquels:

- la figure 1 est un schéma synoptique du système de surveillance automatique de deux batteries d'accumulateurs;
- la figure 2 montre une vue partielle d'un accumulateur témoin équipé d'un ensemble de surveillance de paramètres par satellite et ensemble-capteur de mesure.

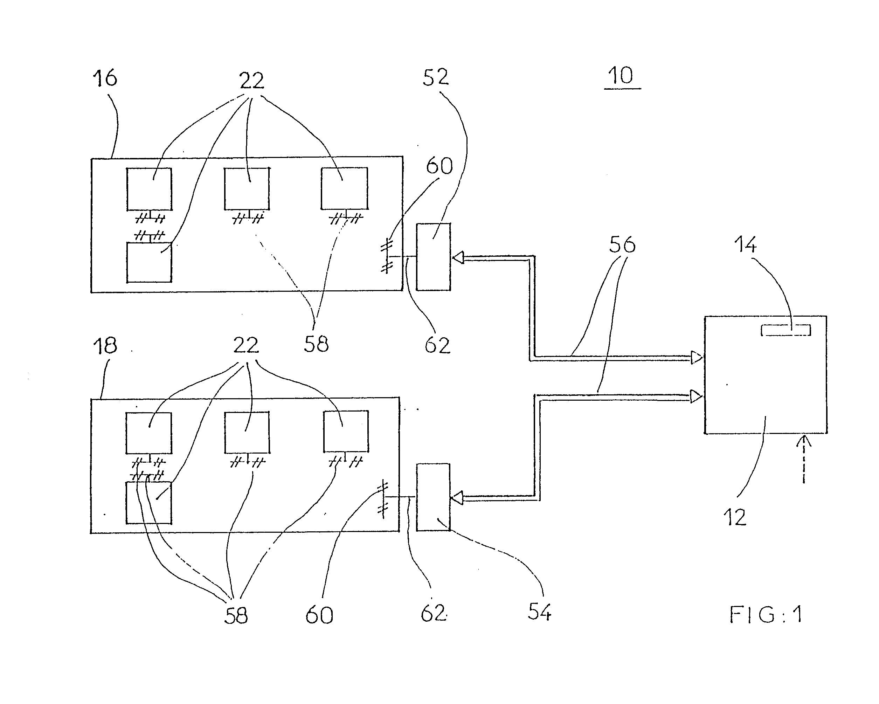

Sur la figure 1, un système de surveillance 10 automatique d'une source de courant continu à batteries d'accumulateurs est équipé d'une unité de traitement centralisée 12 à écran d'affichage 14 pour calculer et indiquer la charge et la capacité disponible par batterie, et à surveiller certains paramètres physiques représentatifs de l'état de fonctionnement des batteries, notamment la densité, la température et le niveau de l'électrolyte à l'intérieur de chaque accumulateur, ou de certains accumulateurs témoins. L'unité de traitement 12 peut être située au poste de conduite et de pilotage d'un sous-marin, tandis que chaque batterie d'accumulateurs est logée dans un local batterie 16,18 éloigné de l'unité centrale 12. La figure 1 montre, à titre d'exemple, deux locaux batteries 16,18 disposés à l'avant et à l'arrière du sous-marin, mais le nombre de locaux peut bien entendu être différent en fonction de la place disponible et de la répartition du poids des accumulateurs.

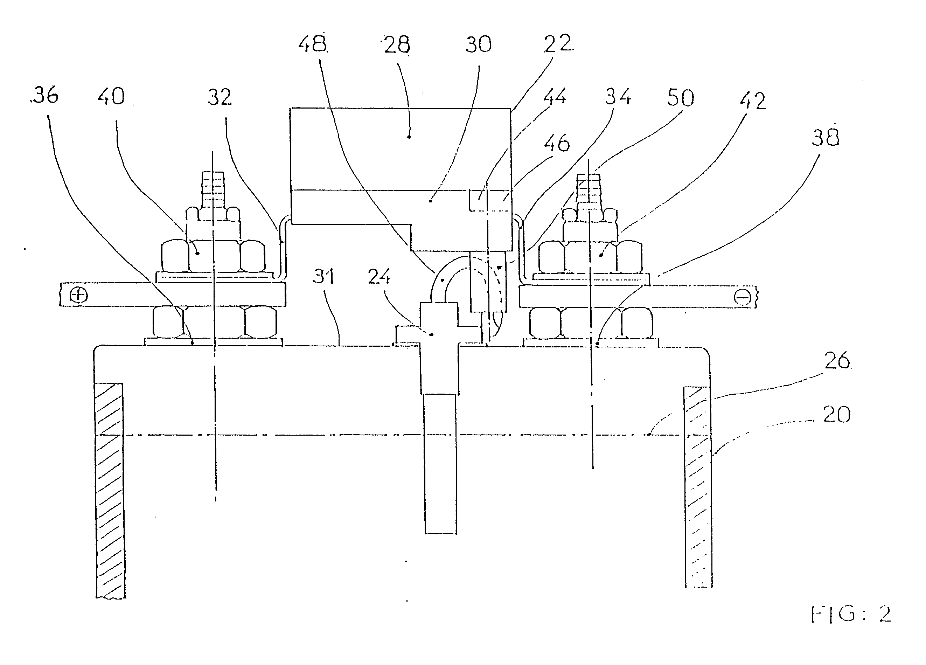

A chaque accumulateur 20 témoin (figure 2) est associé un satellite d'acquisition 22 chargé de mesurer les paramètres physiques grâce à un ensemble-capteurs de mesure 24 ayant différentes sondes de mesure plongées dans l'électrolyte. Le niveau 26 de l'électrolyte est représenté en pointillé sur la figure 2. Le satellite d'acquisition 22 est formé par deux sous-ensembles accolés comprenant à la partie supérieure un boîtier 28 de logement des cartes électroniques, notamment de mesure, de transmission et d'alimentation, et à la partie inférieure, un bloc support 30 en matériau isolant fixé sur le couvercle 31 de l'accumulateur. Le maintien du boîtier 28 sur le bloc support 30 est assuré par un système mécanique de fixation démontable (non représenté). Le bloc support 30 comprend des conducteurs de connexion électrique 32,34 raccordés directement aux bornes de raccordement 36,38 de polarités opposées de l'accumulateur 20 au moyen des écrous de serrage 40,42. Le boîtier 28 est doté de deux broches 44,46 destinées à s'enficher dans le bloc support 30, de manière à assurer un piquage de l'alimentation pour les cartes électroniques du boîtier 28, à partir de la tension présente entre les bornes de raccordement 36,38 de l'accumulateur. Le satellite d'acquisition 22 est ainsi autoalimenté par la tension délivrée par l'accumulateur 20, cette tension étant de l'ordre de 2 Volts et pouvant évoluer entre 1,7 Volts et 2,7 Volts. Le satellite 22 est disposé au-dessus du capteur 24 dans l'intervalle entre les deux bornes 36,38 de l'accumulateur.

La liaison électrique du capteur 24 avec le satellite d'acquisition 22 s'opère au moyen d'un conducteur souple 48 sous gaine associé à un connecteur 50, lequel est démontable uniquement lorsque le boîtier 28 est désaccouplé du bloc support 30, donc de la source d'alimentation. Le capteur 24 traverse de manière étanche le couvercle 31 de l'accumulateur.

Sur la figure 1, les différents satellites d'acquisition 22 sont logés sur les accumulateurs associés dans les locaux 16,18, chaque satellite 22 étant équipé d'une carte de transmission comprenant un circuit émetteur-récepteur destiné à communiquer par fréquences radio avec un concentrateur de données 52,54 formé par un circuit multiplexeur. Le concentrateur 52,54 est situé à l'extérieur du local batterie 16,18 correspondant, par exemple sur la paroi extérieure du local, et est doté d'une carte de transmission à circuit émetteur-récepteur, chargé de collecter toutes des données émises par les satellites d'acquisition 22. Le concentrateur 52,54 transmet les données collectées vers l'unité de traitement centralisée 12 au moyen d'un réseau à bus de communication 56 bidirectionnelle. Les cartes de transmission du concentrateur et des satellites d'acquisition 22 sont bien entendu accordées sur la même fréquence radio.

Chaque satellite d'acquisition 22 est doté d'une petite antenne 58 intégrée dans le boîtier 28 pour assurer soit l'émission de données de mesure vers le concentrateur 52,54 correspondant, soit la réception d'ordres en provenance dudit concentrateur. La communication par onde radio-électrique s'effectue entre la petite antenne 58 de chaque satellite d'acquisition 22 et une grande antenne 60 commune du concentrateur 52,54 associé. La grande antenne 60 est disposée à l'intérieur du local batterie 16,18 et est reliée au concentrateur 52,54 externe par un câble de liaison 62 traversant la paroi du local batterie 16,18. Cette paroi constitue avantageusement un écran d'isolement formant une cage de Faraday agencée pour autoriser la transmission radio interne entre les antennes 58,60, et pour interdire toute communication radio avec l'extérieur du local batterie 16,18. La communication radio s'opère par ondes VHF et modulation de fréquence.

Les solutions retenues rendent le satellite d'acquisition totalement indépendant. Il est donc possible de changer d'accumulateur témoin en déplaçant le satellite d'acquisition. De plus, l'ensemble-capteur et le boîtier du satellite d'acquisition peuvent être remplacés séparément.

L'unité de traitement centralisée 12 collecte et traite les données issues des deux concentrateurs 52,54 via le réseau 56, et dialogue avec l'opérateur.

Le fonctionnement du système de surveillance 10 selon la figure 1 est le suivant:

Les paramètres représentatifs de l'état d'un accumulateur sont mesurés et envoyés par l'ensemble-capteurs de mesure 24 au satellite d'acquisition 22, lequel effectue d'abord un traitement numérique de ces mesures et en assure ensuite l'émission vers le concentrateur 52,54 associé. Cette transmission des données par radio entre les deux antennes 58,60 d'un même local 16,18 est réalisée après interrogation du concentrateur 52,54, suivie de la reconnaissance du satellite d'acquisition 22 interrogé. Le concentrateur 52,54 retransmet ensuite l'ensemble de ces données vers l'unité de traitement centralisée 12 via le réseau de communication 56. Après calcul, les paramètres ainsi que les autres mesures spécifiques du fonctionnement de la batterie peuvent être visualisés sur l'écran d'affichage 14 dans le poste de pilotage.

Etant donné la possibilité d'un environnement explosif suite à la présence d'hydrogène et d'oxygène dans le local batterie 16,18 ventilé, chaque satellite d'acquisition 22 est protégé contre les dangers d'explosion soit par sécurité intrinsèque, soit par encapsulage. La conception de chaque satellite d'acquisition 22 prévoit à cet effet une distance d'isolement prédéterminée entre certains composants et l'insertion d'une résistance dans toutes les liaisons électriques, notamment les conducteurs de connexion 32,34, pour limiter les courants en cas de courts-circuits aux points de sorties du satellite 22. Ces deux précautions évitent toute étincelle ou tout effet thermique, d'énergie suffisante pour provoquer l'inflammation d'une atmosphère explosive. Pour certaines conditions sévères d'exploitation, le boîtier 28 de chaque satellite d'acquisition 22 peut être rempli par un matériau pulvérulent, ou être noyé par encapsulage dans un "compound".

Le système de surveillance 10 de batteries peut bien entendu être utilisé pour d'autres applications non militaires, notamment sur les navires ou dans les centrales électriques.

Selon une variante, le système de transmission sans fil entre le concentrateur et les satellites d'acquisition peut fonctionner par ondes optiques, notamment à infra-rouge. Les satellites et le concentrateur de chaque local sont alors équipés respectivement d'une diode émettrice et d'une diode réceptrice photosensible.

## Revendications

1. Système de surveillance automatique (10) d'une source de courant continu à batteries d'accumulateurs réparties dans des locaux batteries (16,18) éloignés d'une unité de traitement centralisée (12) associée à un écran d'affichage (14) pour indiquer la charge et la capacité disponible par batterie et pour dialoguer avec l'opérateur, le système comprenant des moyens de surveillance de certains paramètres physiques représentatifs de l'état de fonctionnement d'au moins un accumulateur témoin de chaque batterie, notamment la densité, la température et le niveau de l'électrolyte contenu dans ledit accumulateur témoin, ainsi que la tension d'accumulateur, caractérisé en ce que les moyens de surveillance comportent:

- un satellite d'acquisition (22) connecté à un capteur (24) plongé dans l'électrolyte pour la mesure des paramètres de chaque accumulateur témoin, le satellite (22) étant logé à l'intérieur du local batterie (16,18) correspondant, en étant autoalimenté électriquement par la tension présente aux bornes 36,38 de polarités opposées de l'accumulateur,

- un concentrateur de données (52,54), situé à l'extérieur dudit local (16,18), et agencé pour communiquer d'une part, avec le satellite d'acquisition (22) de chaque accumulateur témoin au moyen d'un système de transmission par ondes, et d'autre part, avec l'unité de traitement centralisée (12) par l'intermédiaire d'un réseau de communication (56) bidirectionnelle.

2. Système de surveillance selon la revendication 1, caractérisé en ce que ledit système de transmission fonctionne par ondes radioélectriques, et en ce que le satellite d'acquisition (22) comporte une carte de transmission à circuit émetteur-récepteur équipé d'une première antenne (58) capable d'émettre des données de mesure vers le concentrateur (52,54) et de recevoir des ordres en provenance de ce dernier.

3. Système de surveillance selon l'une des revendications 1 à 2, caractérisé en ce que le concentrateur de données (52,54) de chaque local batterie (16,18) comporte un circuit multiplexeur de données, et une carte de transmission à circuit émetteur-récepteur piloté par une deuxième antenne (60) disposée à l'intérieur du local batterie (16,18), un câble de liaison (62) traversant la paroi du local batterie pour relier le concentrateur 52,54 à la deuxième antenne 60.

4. Système de surveillance selon l'une des revendications 1 à 3, caractérisé en ce que le satellite d'acquisition (22) est disposé au-dessus du capteur de mesure (24) dans l'intervalle entre les deux bornes (36,38) de l'accumulateur, et comporte des conducteurs de connexion (32,34) électrique raccordés directement audites bornes pour l'autoalimentation des cartes du satellite d'acquisition (22), et/ou du capteur de mesure (24).

5. Système de surveillance selon la revendication 4, caractérisé en ce que le satellite d'acquisition (22) comporte deux sous-ensembles accolés ayant un boîtier (28) de logement de cartes électroniques, et un bloc support (30)

en matériau isolant fixé sur le couvercle (31) de l'accumulateur, un dispositif mécanique de fixation démontable et une liaison électrique enfichable par broches (44,46) entre le boîtier (28) et le bloc support (30).

6. Système de surveillance selon la revendication 5, caractérisé en ce que la liaison électrique du capteur de mesure (24) avec le satellite (22) s'effectue au moyen d'un conducteur (48) souple associé à un connecteur (50), agencé pour être déconnectable lorsque le boîtier (28) est désaccouplé du bloc support (30) après déconnexion des conducteurs (32,34) d'alimentation.

7. Système de surveillance selon la revendication 3, caractérisé en ce que la paroi du local batterie (16,18) comporte un écran d'isolement constituant une cage de Faraday autorisant la transmission radio interne entre les première et deuxième antennes (58,60) respectives du satellite (22) et du concentrateur (52,54).

8. Système de surveillance selon l'une des revendications 1 à 7, caractérisé en ce que le satellite d'acquisition (22) est doté de moyens de protection par sécurité intrinsèque et/ou par encapsulage permettant une utilisation du système dans un environnement explosif.

9. Système de surveillance selon la revendication 1, caractérisé en ce que le système de transmission entre le concentrateur de données (52,54) et ledit satellite d'acquisition (22) fonctionne par ondes optiques, notamment à infra-rouges.

FIG:1

EP 0 356 347 A1

FIG: 2

EP 0 356 347 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-4 280 097  (R.L. CAREY et al.)<br>* revendications 9,10; figures 1,4A,4B *<br>--- | 1-3,9 | G 01 R  31/36 |
| Y | US-A-4 247 811  (E. FINDL)<br>* revendications 1,3,10; figures 1-3 *<br>--- | 1,9 | |
| Y | FR-A-2 427 817  (ROLAND EMBALLAGES)<br>* revendication 1; page 3, lignes 13-30 *<br>--- | 2,3 | |
| A | US-A-4 217 645  (G. H. BARRY et al.)<br>* résumé; figures 10,13,14 *<br>--- | 1 | |
| A | GB-A-2 139 829  (GENERAL ELECTRIC COMPANY)<br>* résumé; page 6, lignes 43-47 *<br>--- | 1 | |
| A | DE-A-3 201 758  (VARTA BATTERIE AG)<br>* résumé; figures 1A,1B *<br>----- | 1 | |
| | | | **DOMAINES TECHNIQUES RECHERCHES (Int. Cl.5)**<br><br>G 01 R  31/36 |

Le présent rapport a été établi pour toutes les revendications

| Lieu de la recherche | Date d'achèvement de la recherche | Examinateur |
|---|---|---|
| BERLIN | 03-11-1989 | LEMMERICH J |